Europäisches Patentamt

European Patent Office

Office européen des brevets

(19)

(11) Numéro de publication : **0 300 885 B1**

## (12) FASCICULE DE BREVET EUROPEEN

(45) Date de publication du fascicule du brevet :
**22.01.92 Bulletin 92/04**

(51) Int. Cl.⁵ : **G11C 17/00,** G06F 11/00,
H02H 3/20, G01R 19/165

(21) Numéro de dépôt : **88401844.1**

(22) Date de dépôt : **15.07.88**

(54) **Circuit intégré à mémoire comportant un dispositif anti-fraude.**

(30) Priorité : **21.07.87 FR 8710286**

(43) Date de publication de la demande :
**25.01.89 Bulletin 89/04**

(45) Mention de la délivrance du brevet :
**22.01.92 Bulletin 92/04**

(84) Etats contractants désignés :
**DE ES GB IT NL**

(56) Documents cités :
**FR-A- 2 254 792**
**US-A- 4 612 630**
**US-A- 4 612 632**

(73) Titulaire : **SGS-THOMSON
MICROELECTRONICS S.A.
7, Avenue Galliéni
F-94250 Gentilly (FR)**

(72) Inventeur : **Kowalski, Jacek
Cabinet BALLOT-SCHMIT 84 avenue Kléber
F-75116 Paris (FR)**

(74) Mandataire : **Ballot, Paul Denis Jacques et al
Cabinet Ballot-Schmit 7, rue le Sueur
F-75116 Paris (FR)**

**Description**

La présente invention concerne les circuits intégrés à mémoire comportant un dispositif anti-fraude.

De nombreux circuits intégrés à mémoire, comportent des mémoires non volatiles du type EPROM, c'est-à-dire des mémoires programmable électriquement et effaçables par exposition sous un rayonnement ultra-violet, ou du type EEPROM, c'est-à-dire des mémoires programmables et effaçables électriquement.

La tendance actuelle consiste à utiliser de plus en plus des mémoires EEPROM car ces mémoires présentent des avantages vis-à-vis des mémoires EPROM, notamment le fait que l'effacement se fasse électriquement, un temps de programmation qui est de l'ordre de dix fois plus court que pour des cellules mémoires EPROM, un courant de programmation nul et également la possibilité d'utiliser une tension de programmation générée à l'intérieur du circuit à partir de la tension d'alimentation Vcc des cellules mémoires.

Les cellules mémoires EEPROM sont programmées par une tension de programmation Vpp qui se situe aux alentours de 20 Volts. Bien que la tension de programmation utilisée soit de 20 Volts, la programmation des cellules mémoire EEPROM a lieu pour des tensions inférieures à cette tension de 20 Volts, ces tensions pouvant atteindre 10 Volts. L'utilisation d'une tension de 20 Volts permet d'assurer un niveau acceptable à la tension de seuil $V_t$ de chaque cellule mémoire.

Or il se trouve que dans la plupart des circuits intégrés on utilise la technologie CMOS. Cette technologie permet par rapport è la technologie NMOS de réduire considérablement la consommation statique et d'augmenter la vitesse et la plage de la tension d'alimentation dans laquelle fonctionne le circuit.

La plage de fonctionnement des circuits en technologie CMOS s'étend en pratique de 2V à 15V. La tension d'alimentation de tels circuits peut donc être de 2 Volts jusqu'à 15 Volts. On remarque que de tels niveaux de tension sont de l'ordre de la tension qui est suffisante à la programmation, ou même supérieurs à cette tension seuil de programmation. Or l'utilisation de tensions d'alimentation proche de cette tension seuil de programmation ou supérieure provoque une détérioration des informations contenues dans la mémoire. De telles tensions d'alimentation sont excessives.

Il peut donc venir à l'esprit à un fraudeur d'utiliser ce phénomène lors de la lecture des cellules mémoires pour modifier l'état des informations stockées dans ces cellules en augmentant la tension d'alimentation afin de détruire des informations gênantes telles qu'un code confidentiel, ou des informations de compte bancaire.

L'invention permet de résoudre ce problème, non pas en empêchant que la tension d'alimentation atteigne le seuil de programmation à partir duquel la lecture se transforme en écriture de toute ou partie de la mémoire, mais de manière inattendue, en prévoyant une cellule témoin dans la mémoire, reliée à un détecteur réalisé par un comparateur à seuil qui reçoit en permanence l'état de la cellule, la sortie du détecteur permettant soit de bloquer l'horloge interne du circuit, soit de déclencher une interruption de la logique interne de manière à protéger la mémoire dès que la tension détectée évolue.

L'invention a donc pour objet un circuit intégré comportant une mémoire programmable et effaçable électriquement dont des cellules comportent un transistor à grille flottante en série avec un transistor d'accès, caractérisé en ce que, en vue d'éviter une altération de l'information stockée dans les transistors à grille flottante, causée par une tension de lecture excessive appliquée à la cellule, le circuit comporte une cellule supplémentaire constituée comme les autres cellules et programmée dans un état où son transistor à grille flottante ne peut pas être rendu conducteur, la grille et la source du transistor à grille flottante de la cellule supplémentaire étant à la masse, le transistor d'accès de cette cellule étant rendu conducteur pendant les opérations de lecture de la mémoire, et un comparateur à seuil relié au drain du transistor à grille flottante pour comparer la tension sur ce drain à la tension de lecture et fournir un signal en cas de baisse anormale de la tension sur le drain.

L'invention sera mieux comprise à l'aide de la description détaillée faite à titre d'exemple indicatif et nullement limitatif en référence aux schémas dans lesquels :

— la figure 1, représente le schéma général d'un circuit intégré selon l'invention ;

— la figure 2, représente le schéma plus détaillé d'une cellule témoin selon l'invention ;

— la figure 3I, et 3II représentent le schéma détaille d'une cellule de la mémoire du circuit intégré lors de la lecture de cette cellule ;

— la figure 4, représente un exemple de réalisation d'un circuit de programmation de la cellule témoin ;

— la figure 5, représente un schéma de réalisation particulière du comparateur selon la figure 2.

Pour faciliter la compréhension on a représenté de manière très schématique un circuit intégré CI qui comporte une mémoire de type EEPROM, c'est-à-dire une mémoire programmable, effaçable électriquement et reprogrammable.

La mémoire comporte un ensemble de cellules mémoires C1, C12 ..., C21, implantées suivant une matrice en lignes et colonnes, chaque cellule étant sélectionnable par une ligne de mot WL1, WL2 ... et par une ligne de donnée (ligne de bit) BL1, BL2 ...

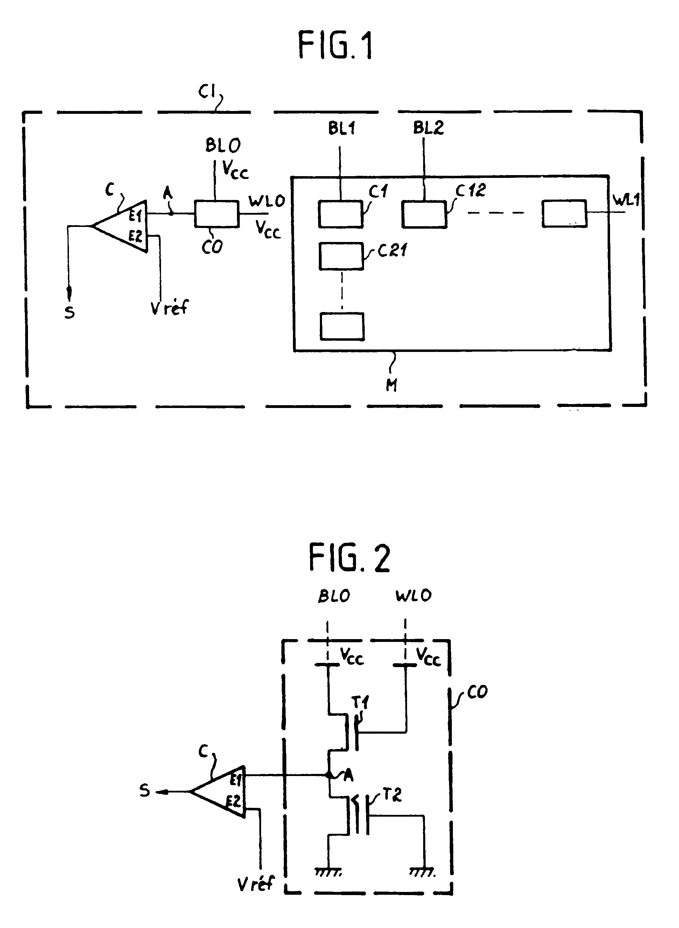

Le circuit intégré comporte selon l'invention une cellule supplémentaire qualifiée de cellule témoin qui est réservée à protéger les cellules de la mémoire contre toute altération des informations stockées produite par une tension de lecture trop excessive de la mémoire. La cellule témoin CO peut être constituée par une cellule de la mémoire sélectionnable par une ligne de mot WLO et par une ligne de bit BLO ou par une cellule extérieure de la mémoire. Elle comporte comme représenté sur la figure 2 un transistor d'accès T1 et un transistor à grille flottante T2.

Le circuit intégré comprend en outre selon l'invention un comparateur C qui reçoit sur une entrée EI le signal lu dans la cellule témoin CO et sur une autre entrée E2, signal de référence Vréf. Le signal de référence Vréf est égal à la tension présente sur le drain du transistor à grille flottante T2 lorsque ce transistor est programmé à "1" et qu'il est rendu non conducteur.

La tension de drain du transistor à grille flottante est égale à la tension de lecture Vcc de la mémoire, diminué de la tension de seuil Vt lorsque la cellule comprend un transistor d'accès de type MOS à canal n. Ce signal de référence Vréf est égal à la tension de lecture Vcc lorsque la cellule comprend un transistor d'accès de type MOS à canal p.

Le comparateur C fournit un signal S lorsque la tension à l'entrée E1 est inférieure à la tension de référence. Le comparateur C fournit donc un signal S lorsque la tension à l'entrée E1 devient inférieure à la tension Vcc-Vt dans le cas d'un transistor d'accès MOS à canal n ou lorsque cette tension devient inférieure à la tension Vcc de lecture dans le cas d'un transistor d'accès à canal p.

Le principe de fonctionnement de l'invention est détaillé à partir du schéma de la figure 2 qui représente la cellule témoin CO et le comparateur C. La cellule témoin CO comporte donc un transistor d'accès T1 (MOS à canal n ou p) et un transistor à grille flottante T2. Le noeud A formé par le drain du transistor T2 et la source du transistor T1 est relié à l'entrée E1 du comparateur C. La cellule a été programmée dans un état tel que le transistor à grille flottante ne puisse pas être rendu conducteur. Ainsi, la cellule est programmée dans l'état "1" ce qui correspond à une tension de seuil Vt du transistor T2 égale à 5 Volts. Le transistor T2 ne conduit pas. La tension au noeud A est égale à Vcc-Vt. Après cette programmation et la programmation de toutes les cellules de la mémoire on peut procéder à une lecture du contenu de la mémoire.

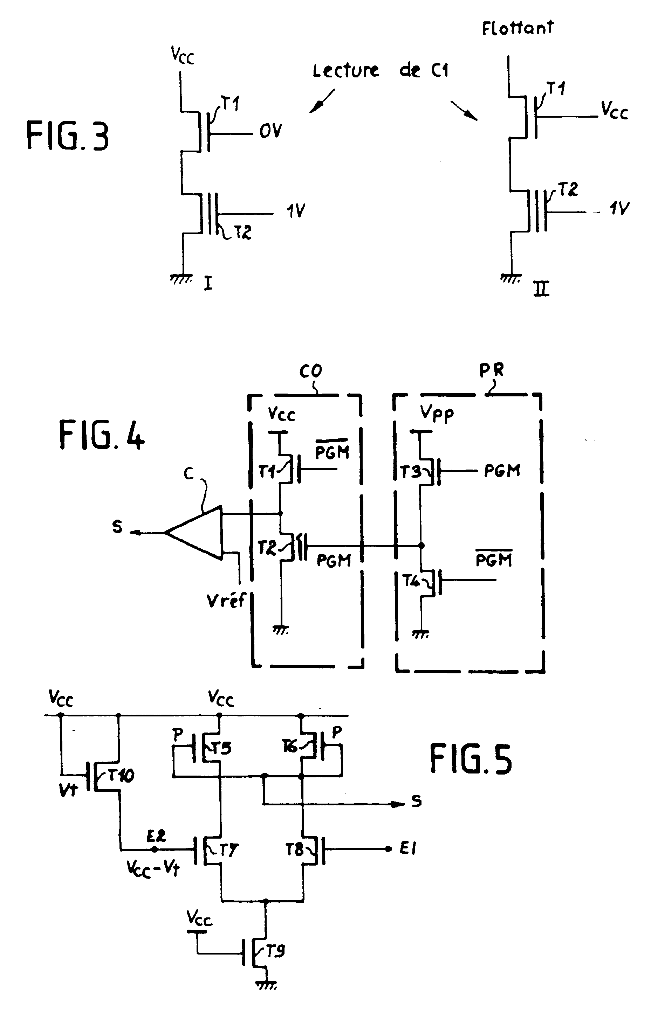

Pour lire les cellules de la mémoire par exemple la cellule C1, on procède de manière classique, comme cela est représenté sur la figure 3 :

I — On effectue une précharge en appliquant la tension de lecture Vcc sur le drain du transistor d'accès T1, 0 Volt sur sa grille, 1 Volt (ou 2 Volts) sur la grille du transistor à grille flottante sa source étant à la masse.

II — On effectue ensuite la lecture proprement dite, en laissant le drain du transistor d'accès flottant, la tension de lecture Vcc étant appliquée sur sa grille, la tension de 1 Volt étant appliquée sur la grille du transistor à grille flottante, la source étant à la masse.

La cellule témoin CO est lue en permanence. Pour cela, le drain du transistor d'accès T1 reçoit la tension de lecture Vcc, la grille de commande de ce transistor T1 reçoit également la tension de lecture Vcc, (comme cela est représenté sur la figure 2). Le transistor T1 est conducteur. La tension au noeud A est égale à Vcc-Vt, le transistor T2 ayant sa grille à 0 Volt. Ce transistor T2 ne conduit pas tant que la tension de lecture Vcc est de l'ordre de 5 Volts à 10 Volts. Lorsque cette tension de lecture Vcc augmente et devient excessive, tout se passe comme si on procédait à l'écriture d'un "O" dans la cellule. En effet, bien que la source du transistor à grille flottante soit à 0 Volt, dès que la valeur de la tension en A atteint la valeur de programmation d'une cellule soit 10 Volts et plus, la grille étant à 0 Volt, les électrons qui avaient été piégés par la programmation d'un "1" ont tendance à partir. Le transistor T2 commence à conduire, sa tension de seuil diminuant. Le potentiel du noeud A baisse.

En effet lorsque la tension de lecture Vcc est augmentée, le potentiel du noeud A suit cette augmentation jusqu'à ce que ce potentiel atteigne une valeur qui rende le transistor T2 conducteur ce qui provoque le départ des électrons qui ont été piégés. Ce phénomène est similaire à l'opération d'écriture d'un "O" dans une cellule d'une mémoire, cette écriture se faisant classiquement par l'application d'une tension de 20 Volts sur la ligne de donnée et sur la ligne de mot et par l'application d'un 0 Volt sur la grille du transistor à grille flottante, la source de ce transistor étant flottante.

Le comparateur C reçoit à l'entrée E1 la tension en A et sur l'entrée E2 la tension de référence pour lui permettre par comparaison à cette référence, de détecter une baisse de tension au noeud A. En effet, le transistor T2, qui est toujours bloqué avec une tension de lecture normale, commence à conduire avec une tension de lecture excessive et cela entraîne une baisse de tension sur le drain de ce transistor c'est-à-dire au noeud A. La tension Vcc-Vt en ce noeud commence à diminuer, et c'est ce début de chute de tension qui est détecté par le comparateur C. La détection d'une chute de tension de 200 mV est suffisante pour empêcher la destruction des informations contenues dans les cellules de la mémoire.

Pour qu'il ne soit pas trop tard et que les cellules de la mémoire ne perdent pas l'information, au cours de la détection d'une chute de tension sur le noeud A, la cellule témoin est rendue plus rapide, lors de la lecture, à la programmation. Cette cellule peut être rendue plus rapide (plus sensible), par exemple en appliquant durant la lecture une tension de 0 Volt sur la grille du transistor à grille flottante T2 alors qu'une tension de 1 Volt ou de 2 Volts est appliquée sur les transistors à grille flottante des cellules de la mémoire. On peut suivant un autre exemple, au lieu d'utiliser des tensions de grille flottante différentes, utiliser un transistor d'accès T1 de taille plus petite que celle des transistors d'accès de la mémoire.

La figure 4, représente une exemple particulier de circuit permettant la programmation ou la reprogrammation de la cellule témoin. Pour programmer la cellule témoin la première fois dans un état "1" ou la reprogrammer dans un état "1", après qu'il y ait eu une détection d'une chute de tension au noeud A, il faut appliquer un signal de programmation PGM sur la grille du transistor à grille flottante T2 correspondant à un état "1", soit une tension de 20 Volts. Il faut également que le signal appliqué sur la grille du transistor d'accès T1 corresponde à un état "O" soit $\overline{PGM}$, qui correspond donc à une tension de 0 Volt, le drain de T1 étant à Vcc et la source de T2 étant à la masse. Le circuit déprogrammation PR qui est donné à titre d'exemple est relié pour la programmation à la cellule CO. Ce circuit comprend deux transistors MOS, le transistor T3 et le transistor T4. Le drain du transistor T3 reçoit la tension de programmation Vpp qui est de 20 Volts. La grille de ce transistor T3 reçoit le signal de programmation PGM et la grille du transistor T4 reçoit le signal $\overline{PGM}$. La source de T3 et le drain de T4 sont reliés entre eux et à la grille du transistor à grille flottante T2 de la cellule témoin. Lorsque la programmation est terminée le signal PGM est à 0 Volt et le signal $\overline{PGM}$ est à "1" soit 5 Volts.

Sur la figure 5, on a représenté un exemple particulier de comparateur détecteur. Ce comparateur C est réalisé par un amplificateur différentiel classique en soi comportant les transistors T5 à T9. La grille du transistor T8 et la grille du transistor T7 forment respectivement les entrées E1 et E2. L'entrée E1 reçoit la tension du noeud A, l'entrée E2 reçoit la tension de référence qui correspond à celle du noeud A, soit Vcc-Vt, tant que ce noeud est isolé c'est-à-dire tant que le transistor T2 ne commence pas à conduire. Ainsi, ces tensions sont identiques tant que la tension de lecture est normale. L'amplificateur différentiel est relié entre les potentiels Vcc et la masse.

Pour obtenir la tension de référence Vcc-Vt à l'entrée de référence, on utilise un transistor T10 dont le seuil est égal au seuil du transistor T1, soit un seuil Vt.

Lorsque les tensions en E1 et E2 sont identiques, les courants passant dans les deux branches de l'amplificateur sont identiques, on obtient une tension de sortie VS de 3 Volts par exemple. Lorsque la tension en E1 baisse, la tension de sortie VS monte à 5 Volts par exemple.

Le signal de sortie du comparateur permet par exemple de bloquer l'horloge interne du circuit intégré soit de déclencher une interruption de logique interne de manière à protéger la mémoire dès que la tension détectée évolue. De telles opérations logiques à l'intérieur du circuit intégré sont du domaine de l'homme du métier.

## Revendications

1. Circuit intégré comportant une mémoire programmable et effaçable électriquement dont les cellules comportent un transistor à grille flottante en série avec un transistor d'accès, caractérisé en ce que, en vue d'éviter une altération de l'information stockée dans les transistors à grille flottante, causée par une tension de lecture excessive appliquée à la cellule, le circuit comporte une cellule supplémentaire (CO) constituée comme les autres cellules et programmée dans un état où son transistor à grille flottante (T2) ne peut pas être rendu conducteur, la grille et la source du transistor à grille flottante de la cellule supplémentaire étant à la masse, le transistor d'accès de cette cellule étant rendu conducteur pendant les opérations de lecture de la mémoire, et un comparateur à seuil (C) relié au drain du transistor à grille flottante (T2) pour comparer la tension sur ce drain à la tension de lecture et fournir un signal en cas de baisse anormale de la tension sur le drain.

2. Circuit intégré selon la revendication 1, caractérisé en ce que le transistor d'accès est un transistor MOS à canal n ayant une tension de seuil Vt et en ce que le comparateur fournit un signal lorsque la tension sur le drain devient inférieure à la tension de lecture diminuée de la tension de seuil.

3. Circuit intégré selon la revendication 1, caractérisé en ce que le transistor d'accès est un transistor MOS à canal p et en ce que le comparateur fournit un signal lorsque la tension sur le drain devient inférieure à la tension de lecture.

## Patentansprüche

1. Integrierte Schaltung mit einem elektrisch programmierbaren und löschbaren Speicher, dessen Zellen einen mit einem Zugriffstransistor in Reihe geschalteten Transistor mit schwebendem Gate aufweisen, dadurch gekennzeichnet, daß die Schaltung zur Vermeidung einer Veränderung der in den Transistoren mit schwebendem Gate gespeicherten Information, die durch eine an die Zelle angelegte übermäßige Lesespannung verursacht wird, eine zusätzliche Zelle (CO), die wie die anderen Zellen aufgebaut ist und in einem Zustand programmiert wird, in dem ihr Transistor mit schwebendem Gate (T2) nicht leitend ist, wobei das Gate und die Source des Transistors mit schwebendem Gate der zusätzlichen Zelle auf Masse liegen und wobei der Zugriffstransistor dieser Zelle während der Operationen des Lesens des Speichers leitend ist, und einen Schwellenwertkomparator (C), der mit dem Drain des Transistors mit schwebendem Gate (T2) verbunden ist, um die Spannung an diesem Drain mit der Lesespannung zu vergleichen und im Falle eines abnormalen Absinkens der Spannung am Drain ein Signal zu liefern, umfaßt.

2. Integrierte Schaltung gemäß Anspruch 1, dadurch gekennzeichnet, daß der Zugriffstransistor ein n-Ranal-MOS-Transistor mit einer Schwellenspannung Vt ist und daß der Komparator ein Signal liefert, wenn die Spannung am Drain unter die um die Schwellenspannung verminderte Lesespannung abfällt.

3. Integrierte Schaltung gemäß Anspruch 1, dadurch gekennzeichnet, daß der Zugriffstransistor ein p-Kanal-MOS-Transistor ist und daß der Komparator ein Signal liefert, wenn die Spannung am Drain unter die Lesespannung abfällt.

**Claims**

1. An integrated circuit comprising an electrically programmable and erasable memory whose cells comprise a floating gate transistor placed in series with an access transistor, characterized in that, with the purpose of avoiding any falsification of the information stored in the floating gate transistors caused by an excessive read voltage applied to the cell, the circuit comprises a supplementary cell (CO) constituted like the other cells and able to be programmed into a condition in which its floating gate transistor (T2) cannot be rendered conducting, the gate and the source of the floating gate transistor of the supplementary cell being connected with ground, the access transistor of this cell being rendered conducting during the operations of reading of the memory, and a comparison means (C) with a threshold said transistor being connected with the drain of the floating gate transistor (T2) in order to compare the voltage at this drain with the read voltage and to supply a signal if there is an abnormal lowering of the voltage at the drain.

2. The integrated circuit as claimed in claim 1, characterized in that the access transistor is an n channel MOS transistor having a threshold voltage Vt and in that the comparison means supplies a signal when the voltage at the drain becomes less than the read voltage diminished by the threshold voltage.

3. The integrated circuit as claimed in claim 1, characterized in that the access transistor is a p channel MOS transistor and in that the comparison means supplies a signal when the voltage at the drain becomes less than the read voltage.

# FIG.1

# FIG.2

FIG.3

Lecture de C1

Flottant

FIG.4

CO  PR

FIG.5